# EUROPÄISCHE PATENTANMELDUNG

(11) **EP 4 152 561 A1**
(43) Veröffentlichungstag der Anmeldung: **22.03.2023**
(21) Anmeldenummer: 22194379.8
(22) Anmeldetag: 07.09.2022
(51) Int. Cl.: H02J 13/00, G01R 29/18, H02J 3/26

(54) **ANORDNUNG UND VERFAHREN ZUR PHASENZUORDNUNG**

(30) Priorität: 15.09.2021 DE 102021123908
(71) Anmelder: Schnabel, Werner, 74821 Mosbach (DE)
(72) Erfinder: Schnabel, Werner, 74821 Mosbach (DE)
(74) Vertreter: Scharfenberger, Burkhard

(57) **Zusammenfassung**

Vorliegende Erfindung befasst sich mit einer Anordnung zur Phasenzuordnung, also zur Zuordnung der an eine mehrphasige Speisespannung angeschlossenen Phasenleiter einer Elektroinstallation zu den einzelnen Phasen der Speisespannung, sowie einem Verfahren zur Phasenzuordnung unter Verwendung einer solchen Anordnung. Die Anordnung umfasst ein Sendegerät mit Senderanschlussmitteln, Referenzerkennungsmitteln, Referenzsignalerzeugungs- und übertragungsmitteln sowie ein Empfängergerät mit Empfängeranschlussmitteln, Phasenvergleichserkennungsmitteln Vergleichsmitteln und Anzeigemitteln.

## Beschreibung

Vorliegende Erfindung befasst sich mit einer Anordnung zur Phasenzuordnung, also zur Zuordnung der an eine mehrphasige Speisespannung angeschlossenen Phasenleiter einer Elektroinstallation zu den einzelnen Phasen der Speisespannung, sowie einem Verfahren zur Phasenzuordnung unter Verwendung einer solchen Anordnung.

Die Elektroinstallation eines Gebäudes, wie beispielsweise eines Wohnhauses oder einer Werkhalle, umfasst üblicherweise eine Mehrzahl von Leitungen, welche von einem zentralen Anschlusspunkt eines externen Stromnetzes zu einzelnen Anschlusspunkten, beispielsweise in Form von Steckdosen, Schaltern oder direkt angeschlossenen Verbrauchern, verlaufen. Die vom externen Anschlusspunkt zu den internen Anschlusspunkten führenden Leitungen umfassen üblicherweise einen Neutralleiter, einen Schutzleiter sowie einen oder mehrere Phasenleiter, auch Außenleiter genannt. Hierbei sind die Neutralleiter (der Leitungen) der Elektroinstallation im Anschlusspunkt an einen externen Neutralleiter angeschlossen, und die Außenleiter jeweils an eine der vom externen Stromnetz zum Anschlusspunkt geführten Phasen. Die aus dem externen Stromnetz hereingeführte Speisespannung umfasst üblicherweise drei Phasen, welche um einen Phasenwinkel von 120° zueinander versetzt sind.

Da die einzelnen Phasen der Speisespannung nicht zu ungleichmäßig belastet werden dürfen, ist beim Aufbau der Elektroinstallation darauf zu achten, dass die internen Anschlusspunkte leistungsmäßig möglichst gleichmäßig auf die Phasen der externen Speisespannung verteilt sind. Unter diesem Gesichtspunkt werden die internen Anschlusspunkte vom Elektroinstallateur auf die verschiedenen Phasen aufgeteilt. Da die Leitungen zu den einzelnen internen Anschlusspunkten üblicherweise in Kabeln zusammengefasst und diese wiederum unter Putz oder zumindest in Kabelkanälen verlegt werden, ist diese Zuordnung der Anschlusspunkte zu den Phasen, sofern sie nicht bei der Installation dokumentiert wurde, was häufig nicht geschieht, nachträglich nur schwer zu ermitteln.

Jedoch gerade wenn die Installationen nachträglich verändert werden, oder ein neuer Verbraucher, insbesondere einer mit hoher Leistungsaufnahme, angeschlossen werden soll, ist es häufig wichtig zu wissen, welche der Phasen der Speisespannung hierdurch belastet würde. Es ergibt sich in diesem Falle das Problem, die bei der Erstellung der Elektroinstallation getroffene Zuordnung zu ermitteln. Im Falle eines einzelnen internen Anschlusspunkts, etwa einer einzelnen Steckdose oder eines einzelnen direkt angeschlossenen Verbrauchers, mag dies im Zweifel noch mit vertretbarem Zeitaufwand möglich sein. Ein erheblicher Zeitaufwand ergibt sich aber dann, wenn die besagte Zuordnung für die komplette Elektroinstallation nachträglich zu ermitteln ist. Im Falle eines mittleren Einfamilienhaus kann ein Elektriker hiermit bisher durchaus mehrere Stunden beschäftigt sein.

Im Stand der Technik sind Vorrichtungen und Verfahren bekannt, mit denen die Phasenzuordnung eine Elektroinstallation erleichtert oder automatisiert erfolgen kann. So stellt beispielsweise die US-Patentschrift US 9,568,522B2 ein Verfahren vor, bei dem mittels an verschiedenen Punkten der Elektroinstallation eingefügter Leistungsmessgeräte ermittelter Verbrauchsdaten zentral zusammengeführt und ausgewertet werden. Hierbei wird eine Korrelation zwischen den durch die verschiedenen Messgeräte gemessenen zeitlichen Verläufen der Leistung errechnet und die Messgeräte dann anhand der errechneten Korrelation den einzelnen Phasen zugeordnet, wobei zwei Messgeräte dann der gleichen Phase zugeordnet werden, wenn die Korrelation zwischen ihnen einen bestimmten Wert überschreitet.

Das dort vorgestellte Verfahren basiert darauf, dass durch Verbraucher verursachte Belastungen und deren zeitliche Änderungen jeweils nur die Phase oder Phasen betreffen, an denen der jeweilige Verbraucher hängt. Einen durch eine erhöhte Leistungsaufnahme eines Verbrauchers an einer Phase verursachten Spannungsabfall dieser Phase überträgt sich hierbei auch an alle anderen dieser Phase angeschlossenen Verbraucher, was entsprechend von den den anderen Verbrauchern vor- oder nachgeschalteten Messgeräten erfassbar ist.

Der Nachteil dieses Verfahrens ist, dass das Vorhandensein von Leistungsmessern vorausgesetzt wird, welche ihre Daten mit einer zentralen Auswertestelle, beispielsweise durch Drahtlosübertragung, teilen können. Zudem ist die beschriebene Methode der Zuordnung über Korrelationen in den zeitlichen Verläufen der Leistungsaufnahmen einzelner Verbraucher weniger verlässlich als andere Methoden.

Ein weiteres Verfahren und eine Vorrichtung zur Phasenzuordnung über ein mehrphasiges Energieversorgungsnetz wird in der Offenlegungsschrift DE196 21 543 A1 vorgestellt. Dort wird eine Anordnung aus einem Lastmodifikationsmodul und ein Laststeuerungsmodul vorgeschlagen, wobei das Lastmodifikationsmodul an eine zu bestimmende Phase angeschlossen und durch dieses dann der Phase eine zusätzliche elektrische Last aufgelegt wird. Das Laststeuermodul ist mit allen Phasen des Mehrphasennetzes verbunden und kann registrieren, auf welche der Phasen sich die zusätzliche, durch das Lastmodifikationsmodul hervorgerufene Belastung auswirkt. Das Ergebnis dieser Phasenzuordnung wird mittels einer Anzeigeeinheit des Laststeuerungsmoduls wiedergegeben.

Der Nachteil hierbei ist, dass eine zusätzliche Last auf eine zu prüfende Phasenleitung aufgeschaltet wird, was einen zusätzlichen Energieverbrauch und auch eine mögliche unerwünschte Emission von Radiostrahlung durch das Auf- und Abschalten der Last nach sich ziehen kann. Beim Aufschalten der zusätzlichen Last muss insbesondere darauf geachtet werden, dass keine zu hohe Belastung der an die zu prüfende Phasenleitung angeschlossene Phase erfolgt. In einer Situation, in der die Zuordnung der einzelnen Phasenleiter auf die Phasen der Speisespannung zunächst einmal nicht bekannt ist, besteht also immer die Gefahr einer Überlastung der zu prüfenden Phasenleitung.

In der Offenlegungsschrift DE 10 2011 087 280 A1 wird ein System von vernetzten Hausgeräten vorgestellt, von denen jedes eine gemeinsame Zeitbasis sowie eine Erkennungseinrichtung zu einer Zeitmesseinrichtung zur Bestimmung eines Nulldurchgangs der Spannung einer Phase, in welches das Gerät angeschlossen ist aufweist. Auf ein Interuptsignal eines der Hausgeräte, oder einer zentralen Steuerung hin starten alle der vernetzten Hausgeräte eine Zeitmessung und bestimmen die Zeiten der Nulldurchgänge der Phase, an der sie angeschlossen sind. Die Erkennungseinrichtung jedes der Hausgeräte verfügt zudem über einen Phasenzuordner, der anhand der gemessenen Zeiten des jeweiligen Hausgeräts sowie der über das Datennetzwerk erhaltenen Messzeitpunkte der anderen Hausgeräte eine Zuordnung vornimmt, an welcher der Phasen das jeweilige Hausgerät angeschlossen ist. Das Ergebnis wird dann auf eine Anzeige des jeweiligen Hausgeräts angezeigt.

Der Nachteil bei diesem System ist, dass alle Hausgeräte eine interne Uhr und eine gemeinsame Zeitbasis benötigen um die absoluten Zeitpunkte der Nulldurchgänge ihrer jeweiligen Phase bestimmen zu können. Diese internen Uhren müssen, um ein verlässliches Ergebnis zu gewährleisten, vergleichsweise aufwändig über einen Netzwerksynchronisierungsalgorhythmus, beispielsweise vorgeschlagen wird ist das Network Time Protocol (NTP) oder das Precision Time Protocol (PTP), synchronisiert werden. Weiterhin ist ein Zuordner nötig, um aus dem Vergleich der einen Messergebnisse mit den von anderen Hausgeräten gemessenen Zeiten eine Zuordnung zu einer der Phasen zu ermöglichen. Hierdurch wird die Erkennungseinrichtung aufwändiger und komplexer. Schließlich ist die Erkennungseinrichtung in ein Hausgerät integriert, was ebenfalls Komplexität und Platzbedarf erhöht und die Tragbarkeit einschränken kann.

Vorliegende Erfindung hat sich vor diesem Hintergrund die Aufgabe gestellt, unter Verwendung simpler und kompakter Geräte eine einfache und schnelle Phasenzuordnung zu ermöglichen.

Gelöst wird diese Aufgabe durch eine Anordnung gemäß Anspruch 1 sowie ein Verfahren gemäß Anspruch 13.

Die Anordnung umfasst hierbei ein Sendegerät und mindestens ein Empfängergerät, wobei das Sendegerät über Senderanschlussmittel mit mindestens einem Phasenleiter und einem Neutralleiter der Elektroinstallation elektrisch verbindbar ist, wobei nach dem Verbinden des Referenzerkennungsmitteln die Zeitpunkte bestimmt, zu der die Spannung einer Referenzphase eines als Referenz dienenden der angeschlossenen Phasenleiter einen oder mehrere vorgegebene Phasenwinkel erreichen, Referenzsignalerzeugungsmittel, die ein die erkannten Referenzzeitpunkte kodierendes Referenzsignal erzeugen, sowie Referenzsignalübertragungsmittel um dieses Referenzsignal an den oder die Empfängergeräte zu senden.

Das Empfängergerät wiederum umfasst Empfängeranschlussmittel zum Anschluss an einen der Phasenleiter und einen Nullleiter der Elektroinstallation wobei die von dem angeschlossenen Phasenleiter getragene Phase als Empfängerphase bezeichnet wird, über Referenzsignalempfangsmittel, die das vom Sender ausgesendete Referenzsignal empfangen können, und Phasenvergleichserkennungsmittel, die es dem Empfängergerät ermöglichen, die Vergleichszeitpunkte zu ermitteln, zu dem die Empfängerphase den oder die vorgegebenen Phasenwinkel erreicht. Weiterhin umfasst das Empfängergerät Vergleichsmittel, welche in der Lage sind aus den ermittelten Vergleichszeitpunkten und den dem Referenzsignal entnommenen Referenzzeitpunkten einen Zeitversatz und/oder einen Differenzwinkel zu bestimmen sowie Anzeigemittel, mittels derer einem Benutzer dieser Zeitversatz und/oder Differenzwinkel zumindest näherungsweise zur Anzeige gebracht werden kann, wodurch dieser eine Zuordnung des an das das Empfängergerät angeschlossenen Phasenleiters zu einer der Phasen der Speisespannung vornehmen kann.

Die Referenz und die Vergleichszeitpunkte werden hierbei von dem Sender bzw. Empfänger relativ zu einem einfach zu ermittelnden und gleichartigen Referenzpunkt im Spannungsverlauf einer Phase, beispielsweise und bevorzugt dem aufsteigendem Nulldurchgang der jeweiligen Spannung ermittelt.

Die vorgegebenen Phasenwinkel können im Sende- wie im Empfangsgerät fest vorgegeben sein. Alternativ können sie auch durch den Benutzer einstell- oder programmierbar sein.

Das durch Sende- und Empfangsgerät durchgeführte Erkennen des Erreichens bestimmter Phasenwinkel bedeutet nicht, dass diese tatsächlich explizit die Winkel als Zahlenwert, egal ob in Grad oder rad oder einer anderen Winkeleinheit, messen oder errechnen. Vielmehr soll hierunter vorliegend jede Erkennung eines bestimmten Spannungswertes, welcher im Rahmen einer sinusförmigen Spannung einem bestimmten Phasenwinkel zuordenbar ist, verstanden werden. Beispielsweise können in manchen Ausführungsformen der Erfindung die Erkennungsmittel von Sende- und Empfängergerät jeweils zur Erkennung der Nulldurchgänge und/oder der Extremwerte der jeweils anliegenden Spannung eingerichtet sein. Hierbei können die Referenz- und/oder Vergleichszeitpunkte direkt durch Zeitmessung erfasst werden, ohne das eine explizite Phasenwinkelbestimmung erfolgt. In manchen Ausführungformen erfolgt weder eine explizite Zeit noch eine Winkelmessung, sondern einfach eine Signaltransformation der Referenzphasenspannung und/oder Vergleichsphasenspannung bzw. phasengetrennter aber -getreuer Abbilder hiervon.

Das Referenzsignal kann in manchen Ausführungen erzeugt werden, indem für jede Periode mittels eines internen Timers die Zeitpunkte der Nulldurchgänge festgehalten und dann ein Referenzsignal erzeugt wird, welches diese Zeitpunkte kodiert. Dies kann ein Datensignal sein, welches, bevorzugt für jede Periode der am Sendegerät anliegenden Spannung, die gemessenen Zeitpunkte als binäre Zahlennwerte an das Empfangsgerät übermittelt. Alternativ kann das Referenzsignal ein Rechtecksignal sein, bei dem die Auf- und Absteigenden Flanken jeweils mit den Zeitpunkten der Nulldurchgänge, bzw. allgemein den Zeitpunkten, zu denen die vorgegebenen Phasenwinkel erreicht werden, korrespondiert.

Eine besonders einfache, simple und effektive Methode zur Erzeugung eines Referenzsignals ergibt sich dadurch, dass ein phasengetrenntes Abbild der Phasenspannung als Eingangssignal eines Verstärkers mit hohem Verstärkungsfaktor (gain) verwendet wird, dessen Ausgangsspannung, etwa natürlicherweise durch eine Versorgungsgleichspannung, auf einen Maximalwert begrenzt ist. Durch eine solche Schaltung wird eine sinusförmige (Eingangs-)Spannung in eine Rechteckspannung transformiert. Die negative oder die positive (negative) Halbwelle kann hierbei abgeschnitten werden, sofern das Referenzsignal keine positiven (negativen) Spannungswerte umfassen soll. Durch diese Transformaton des sinusförmigen Referenzphasenspannungsabbilds in ein Rechtecksignal, kodiert dieses auf natürliche Weise in seiner aufsteigenden (absteigenden) Flanke den aufsteigenden (absteigenden) Nulldurchgang der Referenzphasenspannung.

Im Gegensatz zum Stand der Technik wird im Rahmen vorliegender Erfindung also keine absolute Zeitmessung vorgenommen und somit erübrigt sich auch eine aufwendige Synchronisierung von internen Uhren, wie dies bei dem System der DE 10 2011 087 280 A1 nötig ist.

Das Referenzsignal, insbesondere Rechtecksignal, wird dann entweder in analoger oder digitalisierter Form an das Empfängergerät weitergegeben, wo die darin kodierten Referenzzeitpunkte mit den dort erkannten Vergleichszeitpunkten verglichen werden um einen Zeitversatz oder eine Differenzwinkel zu ermitteln.

Eine Möglichkeit hierzu ist, dass das Empfängergerät in gleicher weise wie das Sendegerät aus der anliegenden Empfängerphasenspannung oder einem potentialgetrennten Abbild hiervon eine Rechteckspannung erzeugt, welche in Frequenz und Amplitude mit dem empfangenen Referenzsignal übereinstimmt. Die beiden Signale können dann voneinander subtrahiert werden, wodurch ein Rechtecksignal entsteht, welches die gesuchte Zeitdifferenz kodiert, welche dann aus diesem extrahiert werden kann. Der Phasenwinkel lässt sich hieraus bei Bedarf durch Verhältnisbildung mit der Periode T und Multiplikation mit 360° errechnen.

In den Ausführungsformen mit einer expliziten Übertragung der Referenzzeitpunkte als binäre Zahlenwerte bestimmt das Empfangsgerät die Vergleichszeitpunkte ebenfalls in binärer Form, etwa mittels einer internen Stoppuhr. Bevorzugt geschieht dies für jede Periode aufs neue. Als Startzeitpunkt wird ein bestimmter Zeitpunkt einer Periode des Sendegeräts gewählt, etwa der aufsteigende Nulldurchgang. Die zeitliche Lage dieses Nulldurchgangs muss dem Sendegerät in analoger Form mitgeteilt werden. Bei der Verwendung eines digitalen oder digitalsierten Referenzsignals erfordert dies die Übertragung ein sekundären Startsignals, etwa eines Signals, welches zu jedem Startzeitpunkt, als dem Beginn jeder Periode, eine zeitlich eng begrenzte Spannungsspitze, etwa in Rechteckform, aufweist. Alternativ kann auch ein Rechtecksignal übertragen werden, welches immer abwechselnd eine Periode mit positiver und eine Periode mit negativer oder verschwindender Spannung aufweist.

Bei den Ausführungsformen der Erfindung, welche ein analoges Referenzsignal verwenden kann das Startsignal und das Referenzsignal vorteilhaft in ein einziges Signal zusammengefasst werden, welches dann sowohl die Information über den Beginn jeder Periode der Referenzphase als auch die Zeitpunkte des Erreichens eines bestimmten Phasenwinkels der Referenzphase kodiert.

Eine einfache Ausführungsform der Anzeigemittel des Empfängers, welche zumindest dann, wenn die Speisespannung nicht mehr als drei Phasen umfasst, zur eindeutigen Zuordnung bereits ausreichend ist, besteht in der Verwendung dreier Lichtquellen, besonders bevorzugt LEDs, wobei jede der Lichtquellen einem bestimmten (minimalen) Zeitversatz bzw. Differenzwinkel zugeordnet ist. Eine der Lichtquellen ist hierbei einem Zeitversatz bzw. Differenzwinkel von (ungefähr) null zugeordnet, leuchtet also nur dann auf, wenn das Empfängergerät beim Vergleich der Differenzzeitpunkte mit den Vergleichszeitpunkten feststellt, dass ein Zeitversatz bzw. Differenzwinkel vorliegt, der, innerhalb der Messgenauigkeit, und/oder einer vorgegebenen, etwa auf der Messgenauigkeit basierenden, Schwelle, einer Nullmessung entspricht oder innerhalb eines ersten, Null enthaltenden, Wertebereichs liegt. Eine zweite der drei Lichtquellen leuchtet auf, wenn ein Zeitversatz oder ein Phasenwinkel gemessen ist, der innerhalb der Messgenauigkeit oder innerhalb einer vorgegebenen, etwa auf der Messgenauigkeit basierenden, Schwelle größer als null ist oder oberhalb einer vorgegebenen ersten Schwelle liegt oder innerhalb eines zweiten, den Winkel 120° enthaltenden, Wertebereichs liegt, und entsprechend die dritte Lichtquelle wenn ein Zeitversatz oder der gemessene Phasendifferenzwinkel innerhalb einer der Messgenauigkeit oder einer darauf basierenden Schwelle kleiner als null oder größer als eine vorgegebene zweite Schwelle, welche in etwa das doppelte der ersten Schwelle beträgt, ist oder innerhalb eines dritten, den Winkel -120° bzw. 240° enthaltenden, Wertebereichs liegt. Hierbei können alle Lichtquellen gleichfarbig sein, oder, bevorzugt durch verschiedene Farben dem Benutzer eine leichtere Erkennung ermöglichen.

Dieses einfache Anzeigemittel ließe sich durch Bildung weiterer Kategorien und Vorgeben weiterer Schwellen auch auf mehr als drei Phasen erweitern. Hierdurch erübrigt sich ein Zuordnungsmittel, wie es noch die Erkennungseinrichtung DE 10 2011 087 280 A1 zur Vornahme der Zuordnung zu einer der Phasen der Speisespannung benötigt.

Alternativ oder zusätzlich kann der Zeitversatz oder der Differenzwinkel auch als Zahlenwert angezeigt werden.

Die in der erfindungsgemäßen Anordnung verwendeten Vorrichtungen in Form des Sendergeräts und des Empfängergeräts verzichten also zum einen auf interne Uhren und deren aufwändige Synchronisierung und kommen zum anderen auch ohne dediziertes Zuordnungsmittel aus. Es ist das Verdienst vorliegender Erfindung, erkannt zu haben, dass die Bestimmung des absoluten Zeitpunktes für das Vorliegen eines bestimmten Referenzphasenwinkels, beispielsweise des Nulldurchgangs (entsprechend eines Phasenwinkels von 0° oder 180°) nicht nötig ist, um eine Zuordnung der Phase vorzunehmen. Hierfür ist es ausreichend, dass der Sender eine der Phasen an die er angeschlossen ist als Referenzphase auswählt und in die der Spannung der Referenzphase erkannten Referenzzeitpunkte in kodierter Form mittels eines Referenzsignals an den Empfänger weitergibt.

Das Referenzsignal kann hierbei ein analoges Signal, beispielsweise ein Rechtecksignal sein, oder es liegt in digitalisierter Form vor. Der durch die Übertragungszeit vom Sender zum Empfänger verursachte Fehler aufgrund der endlichen Signalausbreitungsgeschwindigkeit liegt hierbei im Bereich von etwa 100 Nanosekunden oder weniger im Falle eines Wohnhauses mittlerer Größe (Durchmesser ca. 30 m oder weniger), und bleibt selbst bei der Vermessung von Elektroinstallationen in großen Fabrikhallen (Durchmesser 300 m) im Bereich von lediglich einer Mikrosekunde. Hiermit wäre der so verursachte Fehler um mindestens eine Größenordnung kleiner als die Messgenauigkeit der von den Phasen bzw. Differenz bzw. Phasenvergleichserkennungsmitteln des Senders bzw. Empfängers verwenden Zeitmessmittel, für die eine Genauigkeit von 0,01 bis eine Millisekunde vorgeschlagen wird. Der Fehler ist sogar noch geringer, wenn man berücksichtigt, dass die endliche Signalausbreitung nicht nur das Referenzsignal, sondern auch die in den Leitern der Elektroinstallation propagierenden Phasenspannungen betrifft. Sofern das Sendegerät in der nähe des Anschlusspunkts der externen Speisespannung angeschlossen wird, ergibt sich ein Fehler in der Phasenwinkelmessung nur durch die Differenz der Ausbreitungsgeschwindigkeit von elektromagnetischen Wellen im Vakuum und in einem Leiter.

Durch die erfindungsgemäße Anordnung und das diese verwendende Verfahren ist eine schnelle und simple Ermittlung der Phasenzuordnung in einer Elektroinstallation möglich, welche auch durch eine einzelne Person innerhalb kurzter Zeit durchführbar ist. Hierbei werden die Nachteile der aus dem Stand der Technik bekannten Methoden vermieden. Im Gegensatz zu dem Verfahren, welches in der DE19621543A1 vorgeschlagen wird, ist keine zusätzliche Be- und Entlastung irgendeiner der Phasen der Versorgungsspannung nötig. Ein zusätzlicher Energieverbrauch oder ungewollte Störsignale kommen hierdurch nicht vor. Eine aufwändige Installation einer Mehrzahl von vernetzten Strommessern, wie sie in der US9,568,522B2 vorgestellt wird, kann durch die simple erfindungsgemäße Anordnung aus, im einfachsten Fall, einem Sender und einem Empfänger, ebenfalls vermieden werden. Ähnliches gilt gegenüber der Phasenzuordnung, welche in der DE 10 2011 087 280 A1 vorgestellt wird. Nach der dortigen Lehre sollt jedes einzelne, an die Elektroinstallation angeschlossene Verbrauchergerät über eine eigene Phasenzuordnungseinheit verfügen. Dem gegenüber ergibt sich beim Einsatz vorliegender Erfindung eine deutliche Vereinfachung hinsichtlich des Kostenaufwandes. Dies gilt einmal beim Vergleich der erfindungsgemäßen Anordnung mit dem dortigen System, aber auch beim Vergleich der einzelnen Geräte miteinander, sprich des Senders bzw. des Empfängers mit einem der dort vorgeschlagenen, durch eine Erkennungseinrichtung, welche eine interne Uhr aufweist, ergänzte Haushaltsgeräte, eine vorteilhaft verringerte Komplexität erreicht.

Weitere vorteilhafte Weiterbildung vorliegender Erfindung, welche einzeln oder in Kombination miteinander realisierbar sind, sofern sie sich nicht gegenseitig offensichtlich ausschließen sind den Unteransprüchen zu entnehmen und sollten im Nachfolgenden einzeln vorgestellt werden.

Bevorzugt ist das Referenzsignal ein analoges oder digitalisiertes Rechtecksignal mit einer Frequenz, welcher der Netzfrequenz der Speisespannung entspricht. Hierbei entsprechen die Flanken des Rechtecksignals den erkannten Referenzzeitpunkten, d.h. dass zu dem Zeitpunkt innerhalb einer Periode der Spannung genau zu den erkannten Referenzzeitpunkten eine auf- oder eine absteigende Flanke des Referenzsignals erzeugt wird. D.h. dem ersten bekannten Referenzzeitpunkt entspricht beispielsweise bevorzugt die erste aufsteigende Flanke des Rechtecksignals, dem zweiten erkannten Referenzzeitpunkt wird die erste absteigende Flanke zugeordnet, der zweiten aufsteigenden Flanke entspricht der dritte Referenzzeitpunkt usw.

Als vorgegebene Phasenwinkel, deren Erreichen innerhalb einer Periode der Speisespannung bzw. einer Phase derselben einen Referenzzeitpunkt markiert, werden in manchen Ausführungsformen 0°, 180° oder 0° und 180° gewählt. Diese Werte entsprechen dem ersten (0°) bzw. dem zweiten (180°) der Nulldurchgänge der als sinusförmig angenommenen Spannung einer Phase der Speisespannung. In anderen Ausführungsformen werden 90° und/oder 270° als vorgegebene Phasenwinkel verwendet. Dies entspricht bei einer sinusförmigen Speisespannung den Zeitpunkten, zu denen die Spannung einen Extremwert erreicht. In weiterhin bevorzugten Ausführungsformen wird die jeweilige Phase auf das Erreichen von vier Referenzphasenwinkeln, nämlich insbesondere bevorzugt 0°, 90°, 180° und 270° entsprechend den Nulldurchgängen und den beiden Extremwerten der Phasenspannung überwacht.

Grundsätzlich würde es ausreichen, lediglich einen einzigen Phasenwinkel zu überwachen und den Zeitpunkt, zu dem dieser erreicht wird, als Referenzzeitpunkt zu registrieren. Jedoch wird dadurch, dass eine Phase auf das Erreichen zweier oder mehr Phasenwinkel hin überwacht wird, eine höhere Sicherheit bei der Abgrenzung der verschiedenen Phasen voneinander ermöglicht. Dies gilt jedenfalls insoweit, als die Zeitmessgenauigkeit des verwendeten Zeitmessmittels sowie die Kennungsgenauigkeit des Phasenwinkelerkennungsmittels, welches durch das Phasenreferenzerkennungsmittel des Senders bzw. des Empfängers eingesetzt wird, noch eine Auflösung der jeweiligen Phasenwinkel erlaubt.

Zudem kann die technische Umsetzung Phasenwinkelerkennung auch im Falle mehrere Phasenwinkel einfacher sein, etwa wenn dies dadurch erfolgt, dass die Nulldurchgänge oder die Extremwerte erkannt werden. Hierbei ergeben sich natürlicherweise zwei Zeitpunkte innerhalb einer Periode entsprechend 0 und 180° (Nulldurchgänge) oder 90° und 270° (Extremwerte).

In einer bevorzugten Ausführungsform erkennt das Sendegerät mittels seiner Referenzerkennungsmittel etwa die Nulldurchgänge der Referenzphasenspannung und geben diese mittels des Referenzsignals an das Empfängergerät weiter welches dann den zeitlichen Abstand der Nulldurchgänge der Empfängerphasenspannung misst. Bei einer dreiphasigen Speisespannung mit einer Frequenz von 50 Hz gibt es hierbei drei Möglichkeiten: die Nulldurchgänge der Empfängerphasenspannung können 0, 3,2 oder 6,6 ms nach denen der Referenzphase erfolgen. Dieser gemessenen Zeitversatzwerte zeigt das Empfängergerät dann mittels seiner Anzeigemittel dem Benutzer zumindest in vereinfachter Form an, etwa indem jedem Wert bzw. um die obigen Werte zentrierten Wertebereich mit einer auf der Messgenauigkeit basierenden Breite, eine Leuchte zugeordnet ist, wobei die Leuchten besonders bevorzugt LEDs sind und verschiedene Farben etwa Rot, Grün und Gelb oder Blau, haben.

In Ausführungsformen vorliegender Erfindung, in denen Zeitmessmittel zur Bestimmung der Referenz- und/oder Vergleichszeitpunkte eingesetzt werden, haben diese bevorzugt eine zeitliche Messgenauigkeit von zwischen 0,01 und 1 Millisekunde, bevorzugt zwischen 0,05 und 0,1 Millisekunde.

Darüber hinaus arbeiten die Erkennungsmittel von Sende- und/oder Empfängergerät in bevorzugten Ausführungsformen nicht mit der tatsächlichen Phasenspannung des jeweils angeschlossenen Phasenleiters, sondern sie erhalten ein potentialgetrenntes Abbild derselben, insbesondere einem mit verringerter Amplitude. Hierdurch ist eine galvanische Trennung und somit eine erhöhte Sicherheit vor einer Überlastung der Phasenerkennungsmittel gewährleistet. Im Falle eines Abbilds mit hinreichend verringerter Amplitude kann in der Elektronik der Erkennungsmittel auch mit Niederspannungsschaltelementen gearbeitet werden.

Es ist von vorliegender Erfindung bevorzugt, dass die Anschlussmittel zur Verbindung von Sende- und/oder Empfängergerät mit dem einen oder mehreren Phasen (letzteres nur im Falle des Sendegeräts) und einem Neutralleiter mittels eines Steckers erfolgt, welcher in einer entsprechend mit Phasen und Neutralleiter und ggfs. auch Schutzleiter mit verdrahteten Steckerbuchse eingesteckt wird. Dieser Stecker kann ein CEE7/4, 7/5, 7/7 oder ein 7/16 (Eurostecker) oder, im Falle des Senders, auch ein dreiphasiger CE-Stromstecker sein.

Die Referenzsignalübertragungsmittel des Sendergeräts der erfindungsgemäßen Anordnung ist bevorzugt ein drahtloser Sender, insbesondere ein WIFI, ZigBee oder Bluetooth-Sender. Alternativ oder zusätzlich kann auch ein drahtgebundener Sender eingesetzt werden, insbesondere ein Powerline oder Ethernet-Sender. Der Vorteil von ersterem besteht darin, dass kein zusätzliches Datenkabel zwischen Sende- und Empfängergerät verlegt sein muss, sondern die übertragenen Daten werden direkt der Phasenspannung aufgeprägt.

Die Anzeigemittel des Empfängergeräts umfassen bevorzugt Lichtquellen, insbesondere Leuchtdioden. In besonders bevorzugten Ausführungsformen ist eine Leuchtdiode pro Phase der Speisespannung vorhanden. Diese können in einer besonders prägnanten und leicht verständlichen Variante eine Leuchtdiode mit je einer Farbe, beispielsweise eine rote, eine grüne, und eine blaue Leuchtdiode umfassen, wobei jede Leuchtdiode einer Phase einer dreiphasigen Speisespannung zugeordnet ist.

Die Zuordnung von Diode zu der durch den Sender festgelegten Referenzphase kann entweder fest gewählt sein, sodass beispielsweise ein Aufleuchten der roten Diode bedeutet, dass die am Empfänger anliegende Phase die gleiche ist, die auch am Sender anliegt, ein Aufleuchten der grünen Diode bedeutet, dass die Phase relativ zu der des Senders um 120° nacheilt, und ein Aufleuchten der blauen Diode, dass es sich bei der Empfängerphase um die um 240° nach- bzw. um 120° voreilende Phase handelt.

Alternativ kann die Zuordnung auch frei durch den Benutzer einstellbar sein. Dies ist besonders dann sinnvoll, wenn ein Teil der Elektroinstallation bzw. ein Teil der Phasen der Speisespannung bereits mit einem bestimmten Farbcode markiert wurden. In diesem Fall kann man die Anzeige des Empfängers so einstellen, dass die Farbcodierung der Phasen mit der bereits vorhandenen Markierung übereinstimmt.

Sofern die Anordnung auch zur Vermessung und Zuordnung von Speisespannungen mit mehr als drei Phasen geeignet sein sollen, können auch mehr als drei Lichtquellen vorhanden sein. Alternativ oder zusätzlich kann auch eine LCD- oder TFT-Anzeige oder allgemein eine Anzeige, welche die Darstellung von Zahlen oder Symbolen ermöglicht, vorhanden sein. Hierdurch kann der durch das Vergleichsmittel des Empfängers bestimmte Zeitversatz und/oder der Differenzwinkel unmittelbar angezeigt werden, was es dem Benutzer erlaubt, die Phasenzuordnung anhand des Wissens über die Phasen der Speisespannung selbst vorzunehmen.

Sofern das Vergleichsmittel des Empfängers bei mehreren vorgegebenen Phasenwinkeln für die einzelnen Phasenwinkel zu leicht abweichenden Ergebnissen hinsichtlich des Zeitversatzes und/oder des Differenzwinkels kommt, so wird als Ergebnis der Messung das Arithmetische Mittels der leicht abweichenden Zeitsatze und/oder Differenzphasenwinkel gebildet. Dies gilt insbesondere in Ausführungsformen der Erfindung, in dem Sende- und Empfängergerät mit binären Zahlenwerten der bestimmten Zeitversätze oder Differenzwinkel arbeiten.

In Ausführungsformen von Sende und/oder Empfängergerät verfügen diese alternativ oder zusätzlich zu anderen Sender- bzw. Empfängeranschlussmitteln auch über die Möglichkeit, Phasenleiter direkt anzuklemmen bzw. die Möglichkeit die Spannung eines Phasenleiters an freiliegenden Stellen über geeignete Mittel, beispielsweise isolierte Krokodilklemmen, abzugreifen.

In manchen Ausführungsformen der Erfindung umfasst das Sendegerät einen zum Anschluss an mehrere Phasenleiter geeignetes Sendeanschlussmittel, beispielsweise einen CEE-Drehstromstecker oder mehrere Kontaktleiter mit (Krokodil-)Klemmen, sowie Selektionsmittel zur Auswahl einer der angeschlossenen Phasen als Referenzphase. Bei diesen Selektionsmitteln kann es sich entweder um einen Schiebeschalter, um einen Drehschalter, oder einen Knopf handeln, mit dem nacheinander aus den drei angeschlossenen Phasen eine als Referenzphase ausgewählt wird. Eine Rückmeldung darüber, welche der Phasen gerade als Referenzphase herangezogen wird, kann beispielsweise durch ein entsprechendes, den Anschlüssen zuordenbares Leuchtmittel erfolgen.

In manchen Ausführungsformen der Erfindung, in welchen das Sendegerät über ein im Anschluss an mehrere der Phasenleiter geeignete Anschlussmittel verfügt, ist er zudem auch mit einem Anzeigemittel zum Anzeigen eines Differenzwinkels und/oder eines Zeitversatzes der angeschlossenen Phasen relativ zu einer unter diesen ausgewählten Referenzphasen, ausgestattet.

Im Allgemeinen ist die erfindungsgemäße Anordnung nicht auf einen einzigen Empfänger beschränkt, sondern es können mit einem Sender auch mehrere Empfänger verwendet werden. Hierdurch ist es möglich, an mehr als nur einer Stelle gleichzeitig eine Phasenzuordnung, relativ zur der als Referenz dienenden Phase des Senders vorzunehmen.

In anderen Ausführungsformen der Erfindung handelt es sich beim Sender und Empfänger um baugleiche Einheiten, von denen jede nach Wunsch die Funktion des Senders oder des Empfängers übernehmen kann, wobei mit Hilfe von Umschaltemitteln von einem Sender in Empfangsmodus geschaltet werden kann und umgekehrt. Diese Umschaltemittel können elektromechanischer Form, beispielsweise einen Schalter oder Schiebeschalter sein. Bevorzugt handelt es sich hierbei jedoch um elektronische Umschaltmittel, etwa einen Taster oder einen kapazitiven Schalter. Hierdurch ist erreicht, dass eine Umschaltung auch durch einen elektrischen Impuls ausgelöst werden kann. Beispielsweise kann, sobald ein im Empfangsmodus befindlicher Senderempfängereinheit durch Betätigen des Tasters oder kapazitiven Schalters in den Sendemodus versetzt wird, ein Umschaltsignal an alle im Empfangsbereich befindlichen Senderempfänger geschickt werden, die diese dazu veranlassen, automatisch in den Empfangsmodus zu wechseln. Hierdurch wird vermieden, dass die Referenzsignale zweier oder mehrerer Sender gleichzeitig miteinander kollidieren.

Die erfindungsgemäße Anordnung und das erfindungsgemäße Verfahren werden am Beispiel der Phasenzuordnung einer der Elektroinstallationen eines Gebäudes so eingesetzt, dass das Sendegerät an einen sich bevorzugt in einem Zentralbereich des Gebäudes befindlichen Phasenleiter angeschlossen wird, etwa ein durch Einstecken in eine Steckdose oder direktes Anklemmen an einen oder, je nach Ausführungsform des Sendegeräts, mehrere der Phasenleiter. Dann wird das Empfängergerät nacheinander in alle im Gebäude befindlichen Steckdosen eingesteckt oder mit den Zuleitungen direkt angeschlossener Verbraucher oder Schalter verbunden und die erfindungsgemäße Phasenerkennung durchgeführt. Im Ergebnis erhält man für jeden vermessenen Phasenleiter die Phasenlage relativ zur Referenzphase des Senders. Die Phasenleiter, also Steckdosen, Schalter oder direkt angeklemmten Verbraucher, können dann entsprechend markiert werden.

Sofern auch die Phase von fest angeschossenen Verbrauchern, wie beispielsweise Leuchten, Heizöfen, oder ähnliches, zugeordnet werden sollen, kann der Empfänger direkt mit an die Versorgungsdrähte angeklemmt werden. Im Vergleich zur Vermessung einer Steckdose verzögert sich die Phasenzuordnung hierbei dadurch, dass die Versorgungsdrähte des entsprechenden Verbrauchers erst freigelegt werden müssen, da diese üblicherweise und vorschriftsmäßig durch eine Isolierung gegen Berührung gesichert sind.

Weitere Eigenschaften, Merkmale und Vorteile vorliegender Erfindung ergeben sich aus den nachfolgend anhand der Figuren näher erläuterten Ausführungsbeispiele. Diese sollen die Erfindung lediglich illustrieren und in keiner Weise in ihrer Allgemeinheit einschränken.

Es zeigen:
- Figur 1:: Eine schematische Ansicht einer bevorzugten Ausführungsforms der erfindungsgemäßen Phasenzuordnungsanordnung, an welcher die zugrundeliegende Idee besonders leicht verständlich wird.
- Figur 2:: Eine schematische Ansicht eines Stockwerks eines Gebäudes mit einer Elektroinstallation, welche von einer dreiphasigen externen Speisespannung versorgt wird.
- Figuren 3A,B:: Vorderansichten zweier bevorzugter Ausführungsformen als Teil der erfindungsgemäßen Anordnung verwendbarer Empfängergeräte.
- Figur 4A,B:: Vorderansichten zweier bevorzugter Ausführungsformen von als Teil der erfindungsgemäßen Anordnung verwendbare Empfängergeräte.
- Figure 4C:: Vorderansicht eines als Sende- wie auch als Empfängergerät einsetzbaren Senderempfänger gemäß einer weiteren Ausführungsform.
- Figur 5:: Darstellung von zeitlichen Verläufen von Referenzspannung, Referenzsignal und Vergleichssignal und sich daraus ergebender Differenzphasenwinkel und Zeitversatz.

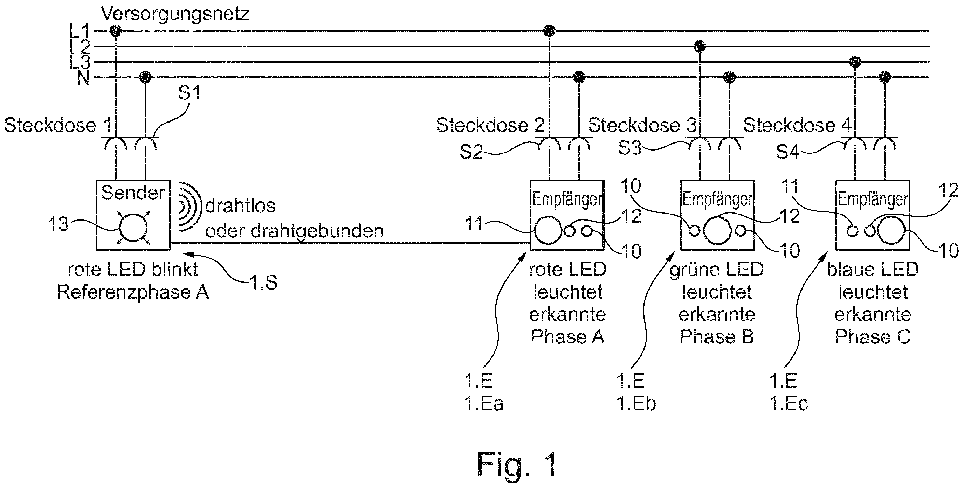

Die **Figur 1** zeigt in Form eines Schaltbildes eine schematische Ansicht einer Ausführungsform der erfindungsgemäßen Phasenzuordungsanordnung. Ein Sendegerät (Sender) 1.S wird an eine Phase L1 und den Neutralleiter eines Versorgungsnetzes angeschlossen, etwa wie dargestellt durch Einstecken in eine Steckdose S1. Selbstverständlich könnte das Sendegerät 1.S alternativ oder zusätzlich auch über entsprechende Anschlussmittel direkt an die Drähte angeklemmt werden. Das Sendegerät 1.S erkennt dann mittels (nicht dargestellter) interner Referenzerkennungsmittel Referenzzeitpunkte, zu denen die als Referenz dienenden Spannung der angeschlossenen Phase L1 einen oder mehrere bestimmte vorgegebene Phasenwinkel erreicht. Es muss hierbei keine explizite Messung oder bestimmung der Phasenwinkel erfolgen, sondern es ist ausreichend, Zeitpunkte zu bestimmen, die bestimmten Phasenwinkeln zuordenbar sind.

Beispielsweise könnten die Referenzerkennungsmittel als Referenzzeitpunkte die Nulldurchgänge der Referenzphase L1 bestimmen. Die Referenzzeitpunkte werden in einem Referenzsignal kodiert drahtlos oder drahtgebunden an einen oderer mehrere Empfänger 1.E weitergegeben, welche jeder mit (irgend)einer der Phasen L1 - L3 verbunden sind, etwa wie dargestellt, dadurch Einstecken in weitere Steckdosen S2, S3, S4 welche jeweils an der Phase L1, L2 und L3 hängen.

Das Sendegerät verfügt in dieser Ausführungsform über eine LED 13, welche durch Blinken anzeigt, dass eine Netzspannung anliegt. Die Empfängergeräte 1.E verfügen als Anzeigemittel über jeweils drei verschiedenfarbige LEDs 10, 11, 12 sowie über, nicht dargestellte, Referenzsignalempfangs-, Vergleichserkennungs- und Vergleichsmittel, mit denen sie das Referenzsignal empfangen, Vergleichszeitpunkte, zu denen die jeweils anliegende Phasenspannung die vorgegebenen Phasenwinkel erreicht erkennen und die Vergleichszeitpunkte mit den Referenzzeitpunkten vergleichen können. Das Vergleichsergebnis, ein Zeitversatz oder Differenzwinkel, wird dann mittels der Anzeigemittel angezeigt. Wird etwa bei einer Netzfrequenz von 50 Hz ein Zeitversatz von etwa 0 ms festgestellt, so leuchtet die LED 11, welche bevorzugt die gleiche Farbe, etwa Rot, hat wie die LED 13 des Sendegeräts 1.S. Im dargestellten Beispiel wird dies bei dem Empfängergerät 1.Ea der Fall sein, welches an die gleiche Phase L1 angesclossen ist wie das Sendegerät 1.S.

Wird vom ein Zeitversatz von 3,2 ms festgestellt, welches beispielsweise der Phase L2 entsprechen könnte, so leuchtet etwa die mittlere, beispielsweise grüne, LED 12. Gleichermaßen leuchtet bei einem Zeitversatz von 6.4 ms, welcher hier dann der dritten Phase L3 entsprechen muss, die rechte, beispielsweise blaue, LED 10.

Werden die Empfängergerät 1.E nun nacheinander in alle Steckdosen eingesteckt, oder anderweitig mit den zuzuordnenden Phasenleitern verbunden, kann deren Phasenzuordnung auch durch einen Laien einfach und schnell bestimmt werden.

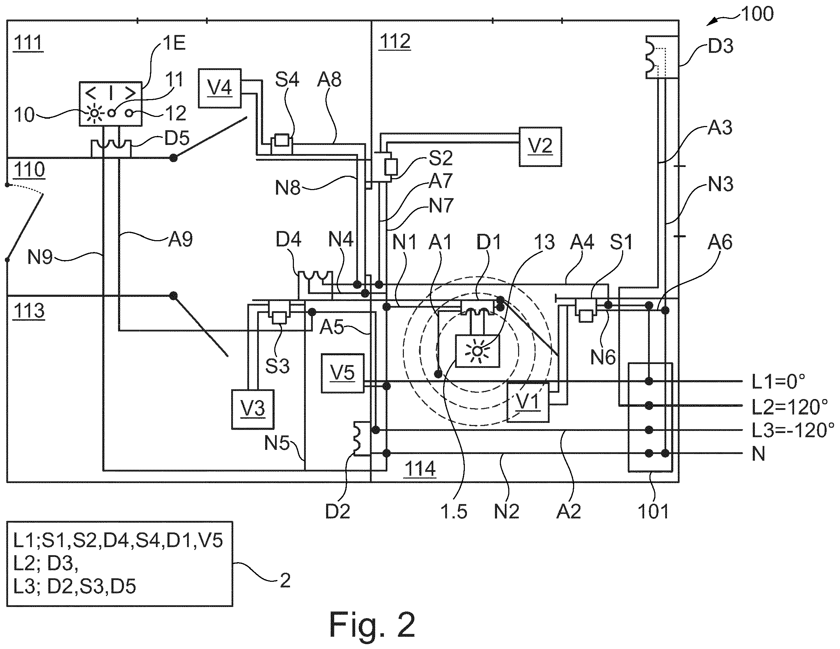

In **Figur 2** ist in schematischer Draufsicht ein Stockwerk eines Gebäudes mit einer Elektroinstallation dargestellt, in der die erfindungsgemäße Anordnung zur Phasenzuordnung zum Einsatz kommt. In der schematisch dargestellten Elektroinstallation wurden zur besseren Übersichtlichkeit die Schutzleiter, welche üblicherweise aus Sicherheitsgründen in jedem Fall Teile einer solchen Installation sein müssten, weggelassen.

Das Gebäude 100 umfasst mehrere Räume 110 - 114 in denen verschiedenen Verbraucher V1 - V5, Schalter S1 -S4 und Netzanschlusspunkte in Form von Steckdosen D1 - D5 verteilt und über Außenleiter A1 - A9 sowie korrespondierende Neutralleiter N1 - N9 mit einem Hausanschlusspunkt 101 verbunden. Im Hausanschlusspunkt 101 sind die in dem Haus 100 verlaufenden Außenleiter A1 - A9 bzw. die Neutralleiter N1 - N9 an von außerhalb des Gebäudes herangeführte Außenleiter L1 - L3, über die eine dreiphasige Speisespannung zugeführt wird, und den externen Neutralleiter N angeschlossen. Jeder der externen Außenleiter L1 - L3 trägt eine Phase der dreiphasigen Speisespannung, wobei die Phasen um 120° zueinander versetzt sind. Die Verbraucher V1 - V5, Schalter S1 - S4 und Steckdosen D1 - D5 sind über die genannten Außenleiter A1 - A9 und Neutralleiter N1 - N9 jeweils an einer der externen Phasen L1 - L3 zuordenbar. Die Zuordnung zu den einzelnen Phasen ist, sofern sie nicht bei der Einrichtung der Elektroinstallation dokumentiert wurde, nachträglich mit herkömmlichen Mitteln nur aufwändig zu rekonstruieren, da hierfür jede der zu den Verbrauchern, Schaltern bzw. Steckdosen führende Leitung zurückverfolgt und ihre Anklemmung im Hausanschlusspunkt 101 überprüft werden muss.

Dank der erfindungsgemäßen Anordnung aus Sender 1.S und Empfänger 1.E ist dies aber erheblich schneller möglich. Wie in der Figur dargestellt, ist der Sender 1.S beispielhaft in die Steckdose D1 in Zimmer 114 eingesteckt, welche über Außenleiter A1 von der Phase L1 versorgt wird. Dass an Dose D1 tatsächlich eine Netzspannung anliegt, wird durch das Aufleuchten der Signalleuchte 13 des Senders 1.S kenntlich gemacht. In der hierfür verwendeten einfachen Ausführung des erfindungsgemäßen Sendegeräts 1.S verwendet automatisch die anliegende Netzspannung als Referenzspannung. Hieraus erzeugt es anhand der vorgegebenen Phasenwinkel ein Referenzsignal, welches drahtlos an Empfangsgerät 1E, welches hier beispielhaft in Steckdose D5 in Zimmer 111 eingesteckt ist, weitergibt.

Das Empfangsgerät 1.E vergleicht die in dem Referenzsignal kodierte Information über die Zeitpunkte, zu denen die Referenzspannung die vorgegebenen Phasenwinkel erreicht mit den Zeitpunkten, zu denen dies für die an der Steckdose D5 anliegende Spannung der Fall ist und zeigt das Ergebnis dieses Vergleichs über die Anzeigemittel an. Vorliegend ist Dose D5 über den Außenleiter A9 an die externe Phase L3 angeklemmt, welche relativ zur Steckdose D1 des Sendegeräts 1.S versorgenden Phase L1 120° vorauseilt. Entsprechend leuchtet am Empfangsgerät 1.E die Leuchte 10, welche eine relativ zur Referenzphase vorauseilende Spannung anzeigt, auf. Die Leuchten 10, 11 und 12 des Empfangsgerät 1.E können zur einprägsameren Kenntlichmachung der Phasen auch unterschiedliche Farben, etwa rot, grün und blau, aufweisen.

Die Zuordnung aller Steckdosen und Verbraucher bzw. Schalter zu den drei Phasen L1, L2 und L3 erfolgt derart, dass das Empfangsgerät 1.E nacheinander mit allen Steckdosen, bzw. zu den Verbrauchern und/oder Schaltern führenden Leitungen verbunden und die Phase relativ zu der Referenzphase bestimmt wird. Hierbei kann das Sendegerät 1.S die ganze Zeit in Steckdose D1 eingesteckt bleiben. Es wäre auch möglich, das Sendegerät 1.S zwischendurch mit einer anderen Steckdose oder einem anderen Schalter oder Verbraucher zu verbinden, welcher auch von der Phase L1 versorgt wird, an welcher die Steckdose D1 hängt. Hierdurch würde sich die verwendete Referenzphase nicht ändern.

Selbstverständlich wäre es auch möglich eine andere Phase als Referenzphase zu wählen. Sofern dies während der Durchführung der Phasenzuordnung erfolgt, würde dies jedoch bedeuten, dass die Phasenbeziehung zwischen der alten und der neuen Referenzphase bei der Interpretation der Zuordnungsergebnisse des Empfangsgeräts 1.E berücksichtigt werden müsste. Der Einfachheit halber ist es daher vorliegend bevorzugt, während der gesamten Zuordnung dieselbe Phase als Referenzphase zu nutzen.

Das Ergebnis der Phasenzuordnung ist die Liste 2, in der die an der jeweiligen Phase L1, L2 oder L3 angeklemmten Steckdosen, Schalter, bzw. Verbraucher, sofern diese wie im Falle des Verbrauchers V5 nicht über einen Schalter, sondern direkt an eine Phase angeklemmt sind, dargestellt.

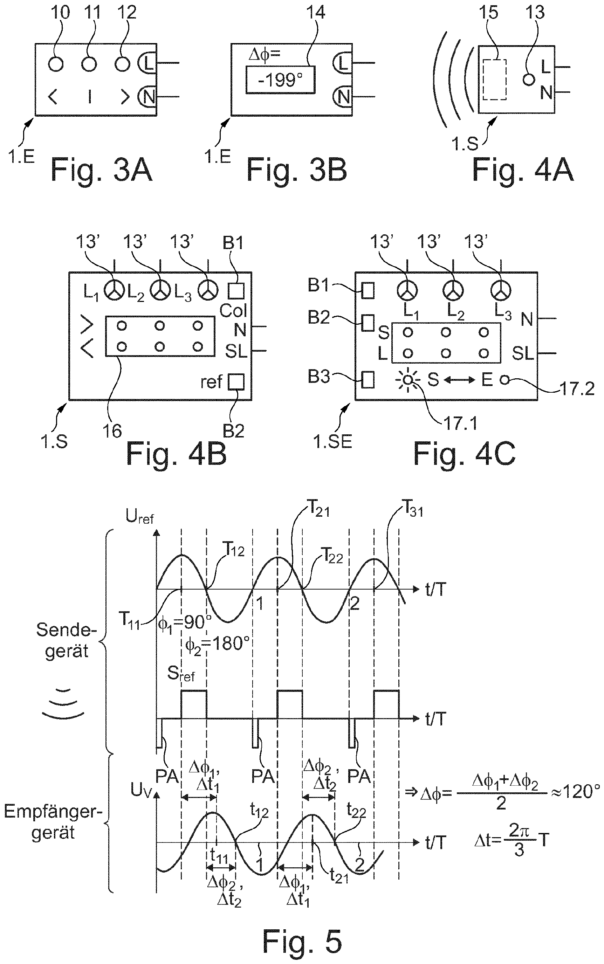

Die **Figuren 3A** und **3B** zeigen schematisch eine Vorderansicht zweier bevorzugter Ausführungsformen eines Empfangsgerätes 1.E.

Das Empfangsgerät 1.E gemäß der **Figur 3A** weist als Anzeigemittel drei Leuchten 10, 11 und 12 auf, welche gleiche oder verschiedene Farben haben können. Wie durch die Symbole "<", "|" und ">" unter den jeweiligen Leuchten angedeutet, leuchtet die Leuchte 10 dann auf, wenn die an dem Kontakt L des Empfangsgerät 1.E anliegende Netzspannung der Referenzspannung, welche an einem mit dem Empfangsgerät 1.E zusammenwirkenden Sendegerät mittels eines Referenzsignals mitgeteilt wird, um einen bestimmten Differenzwinkel, beispielsweise 120°, vorauseilt. Entsprechend leuchtet die Leuchte 12 genau dann auf, wenn die Phase des Empfangsgeräts 1.E der Referenzphase nacheilt und die Leuchte 11 dann, wenn die Phase des Empfangsgeräts 1.E mit der Referenzphase synchron ist.

Die vom Empfangsgerät und dem Sendegerät verwendeten vorgegebenen Phasenwinkel können hierbei fest eingegeben sein, oder es finden sich am Empfangsgerät und/oder am Sendegerät zusätzliche Eingabemittel, mit denen die vorgegebenen Phasenwinkel eingebbar sind. Beispielsweise könnten derartige Mittel am Sendegerät vorhanden sein, welches Informationen über die verwendeten Phasenwinkel dann beim ersten Einschalten oder während eines Programmiervorgangs an das Empfangsgerät, bzw. alle im Empfangsbereich befindlichen Empfangsgeräte, weitergibt. Alternativ kann die Information über die Phasenwinkel auch dem Referenzsignal entnommen werden, sofern dieses um einen in Beginn einer Periode des Referenzphase anzeigenden Signals erweitert wird bzw. kann das Referenzsignal immer zu Beginn einer neuen Periode einen Vorzeichenwechsel vollziehen, oder es kann zur Zeit des Vorzeichenwechsels ein Rechteckpuls von minimaler Dauer vorgesehen werden. Die Lage der vorgegebenen Phasenwinkel kann das Empfangsgerät in diesem Fall einfach anhand der aufsteigenden und absteigenden Flanken des Referenzsignals während einer Periode erkennen.

In **Figur 3B** ist eine weitere Ausführungsform eines erfindungsgemäßen Empfangsgeräts in schematischer Vorderansicht dargestellt. Hier bestehen die Anzeigemittel aus einer LCD-Anzeige 14, auf welcher der relative Phasenwinkel, oder alternativ auch der Zeitversatz zwischen der am Empfangsgerät 1.E anliegenden Vergleichsphase und der am Sendegerät anliegenden Referenzphase angezeigt werden kann. Vorliegend wird beispielsweise ein Phasenwinkel ΔΦ von -119°, entsprechend dem Beispiel aus der Figur 1, dargestellt. Im Allgemeinen wird der Phasenwinkel bei ausreichend genauer Messung nicht exakt dem theoretisch erwarteten Ergebnis, hier -120°, entsprechen. Dennoch ist auch bei Abweichungen, solange diese im Rahmen von etwa +-30° bleiben, eine eindeutige Zuordnung der am Empfangsgerät 1.E anliegenden Phase mit hoher Konfidenz möglich.

In den **Figuren 4A-4C** sind in schematischer Vorderansicht verschiedene Ausführungsformen eines erfindungsgemäßen Sendegeräts dargestellt.

Das Sendegerät der **Figur 4A** umfasst lediglich eine Leuchte 13, welche das Anliegen einer Netzspannung zwischen den Kontakten L und N anzeigt, sowie eine gestrichelt dargestellte interne Sendeeinheit 15 zur Abgabe eines drahtlosen Referenzsignals

In **Figur 4B** ist ein Sendegerät 1.S dargestellt, welches zum Anschluss an mehrere Phasen, hier konkret drei Phasen entsprechend den drei Eingangskontakten L1 - L3, geeignet ist. Hierdurch kann vor bzw. auch während der Durchführung der Phasenzuordnung die Referenzphase ausgewählt werden. Hierfür verfügt das Sendegerät über einen Taster B2, mit dem die jeweils verwendete Phase umgeschaltet werden kann. Mit dem Taster B1 kann die gewünschte Farbe der einzelnen Phasen ausgewählt werden. Bei drei Phasen gibt es hier 6 Möglichkeiten zwischen denen durch wiederholtes Drücken des Tasters B1 nacheinander durchgeschaltet werden kann. Die jeweilige Farbzuordnung wird mittels der Dreifarbenleuchten 13', welchen den einzelnen Phasenkontakten L1, L2 und L3 zugeordnet sind, kenntlich gemacht.

Das Anzeigefeld 16 umfasst zwei Reihen von jeweils drei Leuchten, welche jeweils einer der drei Eingangskontakten L1- L3 zugeordnet sind. Hierdurch kann die Phasenrelation der an den Kontakten L1 - L3 angeschlossenen Phasen bereits am Sendegerät 1.S erkannt werden.

Wird beispielsweise die am Kontakt L1 anliegende Phase als Referenz ausgewählt, und ist die Spannung der Phase L2 gegenüber der Phase L1 um 120° nacheilend, so leuchtet die mittlere Leuchte der oberen Reihe im Anzeigenfeld 16. Die L3 anliegende Spannung wird in diesem Beispiel dann entsprechend um 120° nacheilen, weswegen die rechte Leuchte in der unteren Reihe aufleuchtet. Ebenfalls leuchtet in beiden Zeilen jeweils die linke Leuchte ebenfalls auf, wodurch angezeigt wird, dass die Phase L1 als Referenzphase ausgewählt ist. Alternativ kann dies auch dadurch kenntlich gemacht werden, dass die der Referenzphase zugeordnete Dreifarbenleuchte 13' heller leuchtet als die den anderen beiden Phasen zugeordneten Dreifarbenleuchten.

**Figur 4C** zeigt eine bevorzugte Ausführungsform eines in der erfindungsgemäßen Anordnung verwendeten kombinierten Sende- und Empfangsgeräts. Dieses ähnelt in seinem Aufbau dem Sendergerät der Figur 3B, jedoch verfügt das in Figur 3C dargestellte Sendeempfangsgerät 1.SE zusätzlich über einen Taster B3, mit dem zwischen einem Sende- und einem Empfangsmodus hin und her gewechselt werden kann. Bevorzugt wird dieser Wechsel allen im Empfangsbereich befindlichen anderen Sende- und Empfangsgeräten durch ein entsprechendes Signal mitgeteilt, sodass diese sich automatisch in den entsprechenden Empfangsmodus begeben. Der jeweils aktive Modus wird durch die Leuchten 17.1 und 17.2 angezeigt.

In **Figur 5** ist ein Beispiel des zeitlichen Verlaufs einer Referenzspannung, das anhand zweier Phasenwinkel, hier Φ1 = 90° und Φ2 = 180° von dem Sendergerät generierte, die erkannten Referenzzeitpunkte T₁₁, T₁₂, T₂₁, T₂₂, T₃₁ (usw.) kodierende Referenzsignal S_{ref}, sowie die im Empfängergerät durch Vergleich der Referenzzeitpunkte T₁₁, T₁₂, T₂₁, T₂₂, T₃₁ aus dem Referenzsignals S_{ref} mit den aus der am Empfängergerät anliegenden Spannung erkannten Vergleichszeitpunkten t₁₁, t₁₂, t₂₁, t₂₂, ermittelten Phasendifferenzwinkel Δφ bzw. Zeitversatz Δt dargestellt.

Die sinusförmige Referenzphasenspannung U_{ref} erreicht die vorgegebenen Phasenwinkel Φ₁, Φ₂ in der ersten Periode zu den Referenzzeitpunkten T₁₁, T₁₂ in der zweiten Periode T₂₁, T₂₂ usw. Anhand dieser vom Sendegerät erkannten Referenzzeitpunkte wird das Referenzsignal S_{ref} erzeugt, welches die gleiche Frequenz wie die Referenzspannung U_{ref} hat und Rechteckpulse umfasst, deren aufsteigende Flanke jeweils den ersten Referenzzeitpunkt in jeder Periode T₁₁, T₂₁, T₃₁ usw. und dessen absteigende Flanke jeweils den zweiten Referenzzeitpunkt jeder Periode T₂₁, T₂₂ usw. repräsentiert. Um dem Empfängergerät bei der Ermittlung der Vergleichszeitpunkte eine Synchronisation mit dem Sendegerät zu ermöglichen, umfasst das Referenzsignal S_{ref} zusätzlich zu Beginn jeder Periode einen im Vergleich zur Periodendauer T kurzen, etwa zwischen T/1000 bis T/50 andauernden, negativen Rechteckpuls PA.

Aus dem Vergleich der Referenzzeitpunkte mit den vom Empfängergerät erkannten Vergleichszeitpunkten t₁₁, t₁₂, t₂₁, t₂₂ usw. werden für jede Periode jeweils zwei Differenzwinkel ΔΦ₁, ΔΦ₂ und/oder Zeitversätze Δt₁, Δt₂ ermittelt. Als Vergleichsgesamtergebnis wird das arithmetische Mittel gebildet, welches dann als Grundlage für die mit Hilfe der Anzeigemittel angezeigten Information dient.

### Bezugszeichenliste

- 1.E: Empfangsgerät
- 1.S: Sendegerät
- 1.SE: kombiniertes Sende-Empfangsgerät
- 2: Zuordnungsergebnis
- 100: Gebäude
- 101: Hausanschlusspunkt
- 110-114: Zimmer
- L1-L3: Phasen der externen Speisespannung
- N: externer Neutralleiter
- A1-A9: hausinterne Außenleiter
- N1-N9: hausinterne Neutralleiter
- D1-D5: Steckdosen
- S1-S4: Schalter
- V1-V5: Verbraucher
- 10-13: Anzeigeleuchten
- 13': Dreifarben-Anzeigeleuchte
- 14: LCD-Anzeige
- 15: drahtloser Sender
- 16: Anzeigefeld
- 17.1, 17.2: Betriebsmodus-Anzeigeleuchten
- B1-B3: Taster
- T₁₁ - T₃₁: Referenzzeitpunkte
- t₁₁ - t₂₂: Vergleichszeitpunkte
- φ1, φ2: vorgegebene Phasenwinkel
- Δt₁, Δt₂, Δt: Zeitversatz
- Δφ₁, Δφ₂ , Δφ: Differenzwinkel

## Patentansprüche

1. Anordnung zur Phasenzuordnung, also zur Zuordnung eines oder mehrerer Außen- bzw. Phasenleiter (A1 - 9) einer Elektroinstallation zu einer der Phasen (L1 - 3) einer der Elektroinstallation zugeführten mehrphasigen Speisespannung, umfassend
- ein Sendegerät (1.S, 1.SE) mit
∘ Senderanschlussmitteln zum Anschluss an mindestens einen der Außenleiter und einen Neutralleiter (N1 - 9) der Elektroinstallation, wobei die Phase eines der angeschlossenen Außenleiters als Referenzphase verwendet ist, und
∘ Referenzerkennungsmitteln, zur Erkennung von Referenzzeitpunkten (T₁₁,T₁₂, T₂₁, T₂₂, T₃₁), zu welchen die Spannung der Referenzphase einen oder mehrere vorgegebene Phasenwinkel (φ₁, φ₂) relativ zum aufsteigenden Nulldurchgang erreicht, und
∘ Referenzsignalerzeugungsmitteln, zur Erzeugung eines Referenzsignals (S_{ref}), welches die erkannten Referenzzeitpunkte (T₁₁,T₁₂, T₂₁, T₂₂, T₃₁) kodiert, und
∘ Referenzsignalübertragungsmittel (15) zur Übertragung des Referenzsignals (S_{ref}) an
- mindestens ein Empfängergerät (1.E, 1.SE), mit
∘ Empfängeranschlussmitteln, zum Anschluss des Empfängergeräts (1.E, 1.SE) an einen eine Empfängerphase tragenden Empfängerphasenleiter unter den Außenleitern sowie einen Nullleiter (N1 - 9) der Elektroinstallation, und
∘ Referenzsignalempfangsmitteln, zum Empfang des Referenzsignals (1.E, 1.SE), und
∘ Phasenvergleichserkennungsmitteln, zur Erkennung von Vergleichszeitpunkten (t₁₁, t₁₂, t₂₁, t₂₂), zu denen die Spannung der Empfängerphase den oder die vorgegebenen Phasenwinkel (φ₁, φ₂) relativ zum aufsteigenden Nulldurchgang der Empfängerphase reicht,
∘ Vergleichsmitteln, zur Bestimmung eines Zeitversatzes und/oder eines Differenzwinkels zwischen den dem Referenzsignal (S_{ref}) entnommenen Referenzzeitpunkten (T₁₁,T₁₂, T₂₁, T₂₂, T₃₁) und den erkannten Vergleichszeitpunkten (t₁₁, t₁₂, t₂₁, t₂₂), und
∘ Anzeigemitteln (11, 12, 13, 16) zum Anzeigen einer den Zeitversatz (Δt) und/oder den Differenzwinkel (Δφ) zumindest vereinfacht wiedergebenden Information, wodurch eine Zuordnung des Empfängerphasenleiters zu einer der Phasen (L1 - 3) der Speisespannung möglich ist.

2. Anordnung nach Anspruch 1, **dadurch gekennzeichnet, dass** das Referenzsignal (S_{ref}) ein analoges oder digitalisiertes Rechtecksignal mit einer Frequenz ist, welche einer Netzfrequenz der Speisespannung entspricht, wobei Flanken des Rechtecksignals den erkannten Referenzzeitpunkten entsprechen, insbesondere eine erste aufsteigende Flanke dem Zeitpunkt entspricht, zu dem die Spannung der Referenzphase den kleinsten der vorgegebenen Phasenwinkel erreicht, und weiterhin insbesondere eine erste absteigende Flanke einem Zeitpunkt, zu dem die Spannung der Referenzphase einen zweitkleinsten der vorgegebenen Phasenwinkel (φ₁, φ₂) erreicht oder dem Ende der Periode entspricht.

3. Anordnung nach Anspruch 2, **dadurch gekennzeichnet, dass** das Referenzsignal zur Synchronisierung der Vergleichserkennungsmittel des Empfängergeräts (1.E, 1.SE) mit den Referenzerkennungsmitteln des Sendegeräts (1.S, 1.SE) ein den Beginn und/oder das Ende jeder Periode kennzeichnendes Merkmal (PA) umfasst, insbesondere einen kurzen Rechteckpuls (PA) oder einen Vorzeichenwechsel.

4. Anordnung nach einem der vorhergehenden Ansprüche, **dadurch gekennzeichnet, dass** als vorgegebener Phasenwinkel (φ₁, φ₂)
- 0°, 180° oder 0° und 180° entsprechend dem ersten, dem zweiten oder beiden Nulldurchgängen der Spannung der Referenzphase, oder
- 90°, 270° oder 90° und 270° entsprechend einem oder beiden Extremwerten der Spannung der Referenzphase, oder
- 0°, 90°, 180° und 270° entsprechend den Nulldurchgängen und den Extremwerten der Spannung der Referenzphase verwendet ist.

5. Anordnung nach dem vorhergehenden Anspruch, **dadurch gekennzeichnet, dass** das Sendegerät (1.S, 1.SE) mittels der Referenzerkennungsmittel die als Referenzzeitpunkte die Zeitpunkte der Nulldurchgänge der Referenzphasenspannung bestimmt und das Referenzsignal diese Zeitpunkte insbesondere dadurch kodiert, dass es ein Rechtecksignal ist, dessen Flanken zeitlich mit den Referenzzeitpunkten übereinstimmt oder bei den Referenzzeitpunkten einen im Vergleich zu Periodendauer der Speisespannung kurzen Spannungspuls aufweist.

6. Anordnung nach einem der vorhergehenden Ansprüche, **dadurch gekennzeichnet, dass** die Referenzerkennungsmittel des Sendergeräts (1.S, 1.SE) und/oder die Phasenvergleichserkennungsmittel des Empfängergeräts (1.E, 1.SE)
- ein potentialgetrenntes Abbild der Phasenspannung des jeweils angeschlossenen Phasenleiters erhalten, und/oder
- über Zeitmessmittel mit einer Messgenauigkeit von zwischen 0,01 - 1,0 ms, bevorzugt 0,05 - 0,1 ms verfügen.

7. Anordnung nach einem der vorhergehenden Ansprüche, **dadurch gekennzeichnet, dass** die Senderanschlussmittel einen Stecker, insbesondere einen CEE 7/4, 7/5, 7/7, 7/16 oder ein dreiphasiger CEE-Stromstecker umfassen, und/oder die Empfängeranschlussmittel einen Stecker, insbesondere einen CEE 7/4, 7/5, 7/7,oder 7/16 Stecker umfassen.

8. Anordnung nach einem der vorhergehenden Ansprüche, **dadurch gekennzeichnet, dass** die Referenzsignalübertragungsmittel (15) des Sendegeräts (1.S, 1.SE) einen drahtlosen Sender, insbesondere einen WiFi, ZigBee oder Bluetooth-Sender, und/oder einen drahtgebundenen Sender, insbesondere einen Powerline oder Ethernet-Sender umfassen, und die Referenzsignalempfangsmittel des Empfängergeräts (1.E, 1.SE), ein korrespondierender Empfänger ist.

9. Anordnung nach einem der vorhergehenden Ansprüche, **dadurch gekennzeichnet, dass** die Anzeigemittel des Empfängergeräts (1.E, 1.SE) Lichtquellen, insbesondere Leuchtdioden (10, 11, 12), insbesondere eine Leuchtdiode pro Phase (L1, L2, L3) der Speisespannung, besonders bevorzugt drei Leuchtdioden unterschiedlicher Farbe, und/oder eine Anzeige (14) zur Darstellung von Symbolen, insbesondere eine LCD- oder TFT-Anzeige, umfassen.

10. Anordnung nach einem der vorhergehenden Ansprüche **dadurch gekennzeichnet, dass** das Sendegerät (1.S, 1.SE) ein zum Anschluss an mehrere der Phasenleiter (A1 - A9) geeignetes Sendeanschlussmittel sowie Selektionsmittel zur Auswahl einer der angeschlossenen Phasen als Referenzphase umfasst, .und zusätzlich insbesondere über Anzeigemittel zum Anzeigen eines Differenzwinkels und/oder eines Zeitversatzes der angeschlossenen Phasen relativ zu einer Referenzphase umfasst, wobei die Referenzphase insbesondere mittels Selektionsmitteln des Senders unter einer der angeschlossenen Phasen auswählbar ist.

11. Anordnung nach einem der vorhergehenden Ansprüche, **gekennzeichnet durch** mehr als ein Empfängergerät (1.E, 1.SE).

12. Anordnung nach einem der vorhergehenden Ansprüche, **dadurch gekennzeichnet, dass** Empfängergerät und Sendegerät baugleiche Senderempfängergeräte (1.SE) sind und Umschaltmittel (B3) umfassen, mittels derer die Senderempfängergeräte (1.SE) jeweils zwischen einem Sendemodus und einem Empfangsmodus umschaltbar sind, wobei insbesondere das Umschalten eines im Empfangsmodus befindlichen der Sendeempfänger in den Sendemodus ein automatisches Umschalten der anderen in einem Empfangsbereich befindlichen Sendeempfänger (1.SE) in den Empfangsmodus bewirkt.

13. Verfahren zur Phasenzuordnung der Phasenleiter (A1 - A9) einer Elektroinstallation zu eine der Phasen (L1 - L3) einer mehrphasigen Speisespannung mittels einer Anordnung (1) gemäß eines der vorhergehenden Ansprüche, umfassend die Schritte,
a) Verbinden des Sendegerätes (1.S, 1.SE) mit mindestens einem der Phasenleiter (A1 - A9) der Elektroinstallation, wobei eine von einem dieser Phasenleiter getragene Phase, insbesondere mit Hilfe von Selektionsmitteln des Sendegeräts, als Referenzphase ausgewählt wird,
b) Verbinden des Empfängergeräts (1.E, 1.SE) mit einem der Phasenleiter der Elektroinstallation, sowie einem Neutralleiter (N1 - N9),
c) Erkennung von Referenzzeitpunkten (T₁₁,T₁₂, T₂₁, T₂₂, T₃₁) zu denen die Spannung der Referenzphase einen oder mehrere vorgegebene Phasenwinkel (φ₁, φ₂) relativ zum aufsteigenden Nulldurchgang der Referenzphase erreicht mittels der Referenzerkennungsmittel des Sendegeräts (1.S, 1.SE),
d) Erzeugung eines Referenzsignals, welches die erkannten Referenzzeitpunkte (T₁₁,T₁₂, T₂₁, T₂₂, T₃₁) kodiert mittels des Referenzsignalerzeugungsmittel des Sendegeräts (1.S, 1.SE),
e) Übertragung des Referenzsignals an den Empfänger mittels der Referenzsignalübertragungsmittel,
f) Empfang des Referenzsignal des Sendegeräts (1.S, 1.SE) mittels der Referenzsignalempfangsmittel des Empfängergeräts,
g) Erkennung von Vergleichszeitpunkten (t₁₁,t₁₂, t₂₁, t₂₂), zu denen die Spannung der Empfängerphase den oder die vorgegebenen Phasenwinkel (φ₁, φ₂) relativ zum aufsteigenden Nulldurchgang erreicht mittels der Phasenvergleichserkennungsmittel des Empfängergeräts (1.E, 1.SE),
h) Bestimmung eines Zeitversatzes und/oder eines Differenzwinkels zwischen den dem Referenzsignal entnommenen Referenzzeitpunkten (T₁₁,T₁₂, T₂₁, T₂₂, T₃₁) und erkannten Vergleichszeitpunkten (t₁₁,t₁₂, t₂₁, t₂₂) mittels der Vergleichsmittel des Empfängergeräts (1.E, 1.SE), und
i) Anzeigen einer den Zeitversatz (Δt) und/oder den Differenzwinkel (Δφ) zumindest vereinfacht wiedergebenden Information, wodurch eine Zuordnung des Empfängerphasenleiters zu einer der Phasen (L1 - L3) der Speisespannung möglich wird.

14. Verfahren nach dem vorhergehenden Anspruch, **dadurch gekennzeichnet, dass** das Empfängergerät (1.E, 1.SE) mit weiteren noch nicht zugeordneten Phasenleitern (A1 - A9) der Elektroinstallation verbunden und für jeden dieser weiteren Phasenleiter (A1- A9) die Schritte c - j durchgeführt werden.
